# EUROPEAN PATENT APPLICATION

(11) **EP 4 707 829 A1**
(43) Date of publication of application: **11.03.2026**
(21) Application number: 24843431.8
(22) Date of filing: 11.07.2024
(51) Int. Cl.: G01R 31/389, G01R 31/396, G01R 31/385, G01R 31/382, G01R 19/165, G01R 31/378

(54) **RESISTANCE INCREASE RATE DIAGNOSIS DEVICE AND OPERATION METHOD THEREOF**

(30) Priority: 18.07.2023 KR 20230093380
(71) Applicant: LG Energy Solution, Ltd., Seoul 07335 (KR)
(72) Inventor: HWANG, Insang, Daejeon 34122 (KR); JUNG, Haein, Daejeon 34122 (KR); KIM, Yojin, Daejeon 34122 (KR); PARK, Jinseo, Daejeon 34122 (KR)
(74) Representative: Hoffmann Eitle
(86) International application number: PCT/KR2024/009966
(87) International publication number: WO 2025/018713

(57) **Abstract**

An apparatus for diagnosing resistance increase rate of cellaccording one embodiment of thepresent disclosure may include: a determination unit that determines a reference voltage range based on a discharge profile of a unit cell, an identification unit that identifies a capacity retention rate in a reference voltage range of a unit cell subjected to a specified number of charge-discharge cycles, and a diagnosis unit that diagnoses a resistance increase rate of the unit cell based on the identified capacity retention rate.

## Description

### [TECHNICAL FIELD]

### Cross-Reference to Related Application(s)

This application claims priority from and the benefit of Korean Patent Application No. 10-2023-0093380 filed on July 18, 2023 with the Korean Intellectual Property Office, the disclosures of which is incorporated herein by reference in its entirety.

Embodiments of the present disclosure relate to an apparatus for diagnosing a resistance increase rate of cell and an operation method thereof.

### [BACKGROUND]

Recently, research and development on secondary batteries have been actively conducted.
Here, secondary batteries are batteries that can be recharged and discharged, and includes both conventional Ni/Cd batteries, Ni/MH batteries, etc., and recent lithium ion batteries. Among secondary batteries, lithium ion batteries have an advantage that they have a much higher energy density than conventional Ni/Cd batteries, Ni/MH batteries, etc. In addition, lithium ion batteries can be manufactured small in size and lightweight, and thus can be used as power supplies for mobile devices, and recently, their range of use has expanded to power supplies for electric vehicles, and they are attracting attention as the next-generation energy storage medium.

In general, a secondary battery has a structure in which an electrode assembly is sealed together with an electrolyte within an exterior material and two electrode terminals having mutually different polarities are exposed to the outside. The electrode assembly includes a plurality of unit cells, wherein the unit cell has a structure in which a porous separator is interposed between at least a positive electrode plate and a negative electrode plate. Here, the unit cell may be composed of a mono-cell in which a positive electrode and a negative electrode are respectively positioned on the two outermost sides of cell, a bi-cell in which electrodes having the same polarity are positioned on the two outermost sides of cell, or a half-cell in which a positive electrode or a negative electrode is positioned between the separators on the two outermost sides of cell.

Meanwhile, the importance of technology related to management systems for more efficient use and management of secondary batteries is increasing. In particular, the management system must be able to accurately predict the degree of aging of secondary batteries in order to appropriately adjust the charge or discharge output and capacity usage strategy of the secondary battery.

Aging of a secondary battery occurs when the maximum capacity is not continuously retained at the initial design capacity, but decreases as the charge-discharge cycles progresses. Based on such characteristics, the resistance increase rate and the capacity retention rate are used as parameters for predicting the degree of aging of a secondary battery. For example, the resistance increase rate is calculated based on the capacity retention rate of a secondary battery, and the resistance increase rate is directly related to the degree of aging, and thus, the degree of aging of a secondary battery can be predicted based on the calculated resistance increase rate.

### [DETAILED DESCRIPTION OF THE INVENTION]

### [Technical Problem]

Generally, a positive electrode material is similar in its capacity retention rate behavior and resistance increase rate behavior as the charge-discharge cycles progresses, so that the resistance increase rate of a unit cell including the positive electrode material can be predicted from the capacity retention rate behavior.

However, in the case of the high-manganese positive electrode material having the highest manganese (Mn) content, mutually opposite phenomena occur in which as the charge-discharge cycles progresses, the capacity decreases due to the increase in resistance, and the capacity increases due to activation of manganese oxidation-reduction reactions, which causes a problem that the capacity retention rate behavior in the entire voltage range does not match the resistance increase rate behavior of the unit cell. Therefore, in the case of a unit cell including a high-manganese positive electrode material, it is necessary to determine a voltage range in which the capacity retention rate behavior and the resistance increase rate behavior of the unit cell match each other.

The embodiments disclosed herein can provide an apparatus for diagnosing a resistance increase rate of cell and an operation method thereof, which can diagnose the resistance increase rate based on the capacity retention rate in a reference voltage range where the capacity retention rate behavior and the resistance increase rate behavior of a unit cell including a high-manganese cathode material match each other.

The technical problems of the embodiments disclosed herein are not limited to the above-mentioned technical problems, and other technical problems not mentioned herein can be clearly understood by those skilled in the art from the following descriptions.

### [Technical Solution]

An apparatus for diagnosing a resistance increase rate of cell according to an embodiment of the present disclosure may comprise a determination unit that determines a reference voltage range based on a discharge profile of a unit cell, an identification unit that identifies a capacity retention rate in a reference voltage range of a unit cell subjected to a specified number of charge-discharge cycles, and a diagnosis unit that diagnoses a resistance increase rate of the unit cell based on the identified capacity retention rate.

In the apparatus for diagnosing a resistance increase rate of cell according to an embodiment of the present disclosure, the determination unit may determine a reference voltage based on a slope of the discharge profile, and determine a reference voltage range based on the reference voltage.

In the apparatus for diagnosing a resistance increase rate of cell according to an embodiment of the present disclosure, the determination unit may determine the voltage at an inflection point of the discharge profile as the reference voltage.

In the apparatus for diagnosing a resistance increase rate of cell according to an embodiment of the present disclosure, the determination unit may determine a voltage range of a reference voltage or more and an upper limit voltage or less of the charge-discharge cycles, as the reference voltage range.

In the apparatus for diagnosing a resistance increase rate of cell according to an embodiment of the present disclosure, the identification unit may identify the capacity retention rate based on the change amount of capacity in a reference voltage range of the unit cell subjected to the specified number of charge-discharge cycles.

In the apparatus for diagnosing a resistance increase rate of cell according to an embodiment of the present disclosure, the unit cell may include a high-manganese positive electrode having the highest manganese (Mn) content among its constituent components. Such a high-manganese positive electrode may be a positive electrode containing a lithium metal oxide as a positive electrode active material, in which 50 mol% or more of all the metals excluding lithium are manganese(Mn).

A method for diagnosing a resistance increase rate of cell according to an embodiment of the present disclosure may comprise an operation that determines a reference voltage range based on a discharge profile of a unit cell, an operation that identifies a capacity retention rate in a reference voltage range of a unit cell subjected to a specified number of charge-discharge cycles, and an operation that diagnoses a resistance increase rate of the unit cell based on the identified capacity retention rate.

In the method for diagnosing a resistance increase rate of cell according to an embodiment of the present disclosure, the operation that determines a reference voltage range may comprise an operation that determines a reference voltage based on a slope of the discharge profile, and an operation that determines a reference voltage range based on the reference voltage.

In the method for diagnosing a resistance increase rate of cell according to an embodiment of the present disclosure, the operation that determines a reference voltage may comprise an operation that determines the voltage at an inflection point of the discharge profile as the reference voltage.

In the method for diagnosing a resistance increase rate of cell according to an embodiment of the present disclosure, the operation that determines a reference voltage range may comprise an operation that determines a voltage range of a reference voltage or more and an upper limit voltage or less of the charge-discharge cycles, as the reference voltage range.

In the method for diagnosing a resistance increase rate of cell according to an embodiment of the present disclosure, the operation that identifies a capacity retention rate may comprise an operation that identifies the capacity retention rate based on the change amount of capacity in a reference voltage range of the unit cell subjected to the specified number of charge-discharge cycles.

In the method for diagnosing a resistance increase rate of cell according to an embodiment of the present disclosure, the unit cell may comprise a high-manganese positive electrode having the highest manganese (Mn) content among its constituent components.

### [Advantageous Effects]

According to an embodiment of the present disclosure, the resistance increase rate of a unit cell can be accurately diagnosed based on the capacity retention rate of the unit cell containing a high manganese positive electrode material.

The effects of the apparatus and the method for diagnosing a resistance increase rate of cell according to the present disclosure are not limited to the above-mentioned effects, and additional other effects not mentioned herein will be clearly understood by those skilled in the art from the following descriptions.

In addition, various effects that are directly or indirectly identified throughout the present disclosure can be provided.

### [BRIEF DESCRIPTION OF THE DRAWINGS]

FIG. 1 is a graph showing the results of measuring a capacity retention rate and a resistance increase rate in an entire voltage range corresponding to each charge-discharge cycles while performing charge-discharge cycles in different voltage ranges for the unit cell to be measured.
FIG. 2 is a block diagram of a resistance increase rate diagnosis apparatus according to an embodiment.
FIG. 3 is a diagram explaining an example in which a resistance increase rate diagnosis apparatus according to an embodiment determines a reference voltage range based on a discharge profile of a unit cell.
FIG. 4 is a diagram showing the results of measuring a capacity change amount in a voltage range outside the reference voltage range while performing charge-discharge cycles of mutually different voltage ranges for the unit cell to be measured.
FIG. 5 is a diagram showing the results of measuring a capacity change amount in a reference voltage range while performing charge-discharge cycles of mutually different voltage ranges for the unit cell to be measured.
FIG. 6 is an operation flowchart of a resistance increase rate diagnosis apparatus according to an embodiment.

### [DETAILED DESCRIPTION OF THE EMBODIMENTS]

Hereinafter, various embodiments of the present disclosure will be described in detail with reference to the accompanying drawings. It should be understood, however, that there is no intent to limit the present disclosure to particular embodiments, but embodiments are to cover various modifications, equivalents, and/or alternatives of the embodiments of the present disclosure.

Various embodiments of the present disclosure and terms used in the embodiments are not intended to limit the technical characteristics described herein to specific embodiments, and should be understood as including various changes, equivalents or alternatives of a corresponding embodiment. In relation to the description of the drawings, similar reference numerals may be used for similar or related elements. A singular form of a noun corresponding to an item may include one item or a plurality of items unless explicitly described otherwise in the context.

In the present disclosure, each of phrases, such as "A or B", "at least one of A and B", "at least one of A or B", "A, B or C", "at least one of A, B and C", and "at least one of A, B, or C", may include any one of items listed along with a corresponding one of the phrases or all possible combinations of the listed items. Terms, such as "a first", "a second", "the first", "the second", "A", "B", "(a)" or "(b)" may be used to merely distinguish between an element and another element, and do not limit corresponding elements in another aspect (e.g., importance or order).

It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be disposed separately in other components. According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

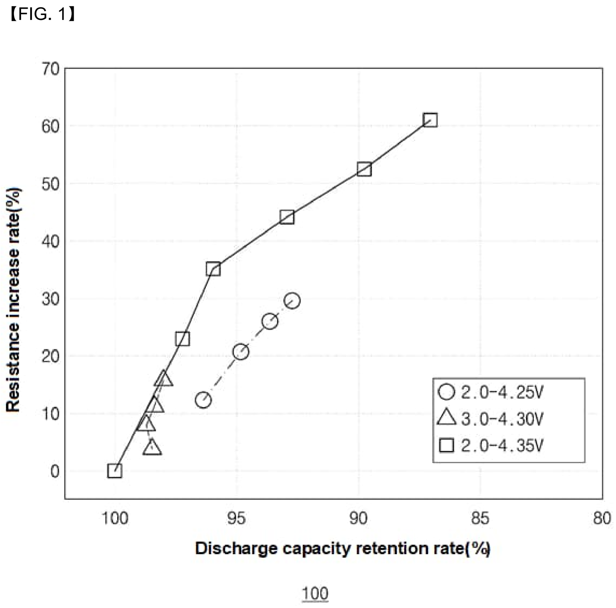

FIG. 1 is a graph showing the results of measuring a capacity retention rate and a resistance increase rate in an entire voltage range corresponding to each charge-discharge cycles while performing charge-discharge cycles in different voltage ranges for the unit cell to be measured.

Referring to FIG. 1, a graph 100 showing the resistance increase rate relative to the discharge capacity retention rate of the same unit cell subjected to a specified number of different charge-discharge cycles can be confirmed. Here, the unit cell may include a high-manganese positive electrode having the highest manganese (Mn) content among its constituent components. The high-manganese positive electrode may be a positive electrode containing a lithium metal oxide as a positive electrode active material, in which 50 mol% or more of all the metals excluding lithium are manganese (Mn), and the lithium metal oxide may be, for example, a lithium- and manganese-rich oxide represented by the following Chemical Formula 1:

[Chemical Formula 1] Liₐ[Ni_{b}Co_{c}Mn_{d}Mₑ]O₂

in Chemical Formula 1, 1.00<a, 0≤b≤0.5, 0≤c≤0.10, 0.5≤d≤1.00, 0≤e≤0.20, and M is at least one selected from the group consisting of Al, B, Co, W, Mg, V, Ti, Zn, Ga, In, Ru, Nb, Sn, Sr and Zr.

According to an embodiment, mutually different charge-discharge cycles may include cycles in which charge-discharge is performed within mutually different voltage ranges (e.g., 2V or more and 4.25V or less, 3V or more and 4.3V or less, or 2V or more and 4.35V or less). In the following, the three charge-discharge cycles of the graph 100 may be referred to as a first charge-discharge cycle (e.g., charge-discharge cycle in a voltage range of 2V or more and 4.25V or less), a second charge-discharge cycle (e.g., charge-discharge cycle in a voltage range of 3V or more and 4.3V or less), and a third charge-discharge cycle (e.g., charge-discharge cycle in a voltage range of 2V or more and 4.35V or less).

Referring to the graph 100, it can be confirmed that in the case of a unit cell subjected to the first charge-discharge cycle or the third charge-discharge cycle, the capacity retention rate behavior and the resistance increase rate behavior have a linear relationship. Specifically, in the case of a unit cell subjected to the first charge-discharge cycle or the third charge-discharge cycle, it can be confirmed that the resistance increase rate increases as the capacity retention rate decreases.

On the other hand, in the case of a unit cell subjected to the second charge-discharge cycle, it can be confirmed that the capacity retention rate behavior and the resistance increase rate behavior have a nonlinear relationship. Specifically, in the case of a unit cell subjected to the second charge-discharge cycle, it can be confirmed that the decrease or increase in the capacity retention rate and the decrease or increase in the resistance increase rate do not match one-to-one each other.

A typical NCM (nickel-cobalt-manganese) positive electrode material shows the tendency that the capacity retention rate behavior and the resistance increase rate behavior following the progress of the charge-discharge cycles match each other. However, in the case of a high-manganese positive electrode material, for example, the lithium- and manganese-rich oxide of Chemical Formula 1, the tendency of the resistance increase rate relative to the capacity retention rate appears to be different from that of a typical NCM positive electrode material, as shown in graph 100. This can be predicted because the lithium- and manganese-rich oxide has a different crystal phase that is mainly activated according to the progress stage and voltage of the charge-discharge cycles, as the two crystal phases, i.e., rock salt phase and layered phase, are mixed.

Therefore, it may be difficult to predict the degree of aging of the high-manganese positive electrode material based on the resistance increase rate in the entire voltage range of the charge-discharge cycles.

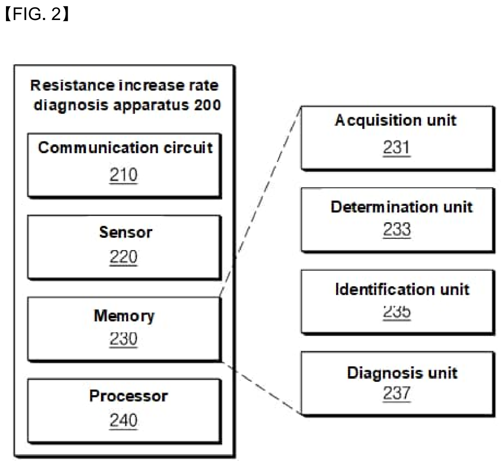

FIG. 2 is a block diagram of a resistance increase rate diagnosis apparatus according to an embodiment.

According to an embodiment, the resistance increase rate diagnosis apparatus 200 may include a communication circuit 210, a sensor 220, a memory 230, and/or a processor 240. According to an embodiment, the resistance increase rate diagnosis apparatus 200 shown in FIG. 2 may further include at least one component (e.g., a display, an input device, or an output device) other than the components shown in FIG. 2.

According to an embodiment, the resistance increase rate diagnosis apparatus 200 can receive values related to the state of the unit cell via the communication circuit 210 and/or the sensor 220. For example, the unit cell may be a unit cell including a high-manganese positive electrode having the highest manganese content among its constituent components. According to an embodiment, the values related to the state may include a discharge profile indicating a voltage according to the discharge capacity of the unit cell during discharge and/or a capacity change amount (or capacity retention rate) of the unit cell subjected to charge-discharge cycles.

According to an embodiment, the communication circuit 210 establishes a wired communication channel and/or a wireless communication channel between the resistance increase rate diagnosis apparatus 200 and an external electronic apparatus and/or an external server, and can transmit and receive data with the external electronic apparatus and/or the external server via the established communication channel. According to an embodiment, the communication circuit 210 can receive values related to the state of the unit cell from the external electronic apparatus and/or the external server.

According to an embodiment, the sensor 220 can measure values related to the state of the unit cell.

According to an embodiment, the configuration of either the communication circuit 210 or the sensor 220 in the resistance increase rate diagnosis apparatus 200 may be omitted. For example, if the sensor 220 is omitted, the resistance increase rate diagnosis apparatus 200 may receive values related to the state of the unit cell from an external electronic apparatus and/or an external server only via the communication circuit 210. As another example, if the communication circuit 210 is omitted, the resistance increase rate diagnosis apparatus200 may measure values related to the state of the unit cell only via the sensor 220.

According to an embodiment, the memory 230 may include volatile memory and/or non-volatile memory.

In an embodiment, the memory 230 may store data used by at least one component (e.g., processor 240) of the resistance increase rate diagnosis apparatus 200. For example, the data may include software (or instructions related thereto), input data, or output data. In one embodiment, the instructions may, when executed by the processor 240, allow the resistance increase rate diagnosis apparatus 200 to perform operations defined by the instructions.

In an embodiment, the memory 230 may include one or more software (e.g., acquisition unit 231, determination unit 233, identification unit 235, and/or diagnosis unit 237).

In an embodiment, the processor 240 may include a central processing unit, an application processor, a graphics processing unit, a neural processing unit (NPU), an image signal processor, a sensor hub processor, or a communication processor.

In an embodiment, the processor 240 may execute software (e.g., acquisition unit 231, determination unit 233, identification unit 235, and/or diagnosis unit 237) to control at least one other component (e.g., a hardware or software component) of the resistance increase rate diagnosis apparatus 200 connected to the processor 240, and may perform various data processing or calculations.

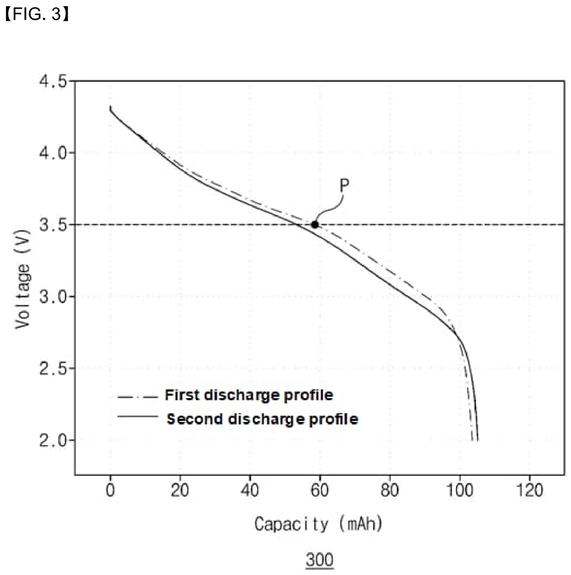

Next, a method in which the resistance increase rate diagnosis apparatus 200 diagnoses an abnormality in a unit cell via the acquisition unit 231, the determination unit 233, the identification unit 235 and/or the diagnosis unit 237 will be described with reference to FIGS. 3, 4 and 5.

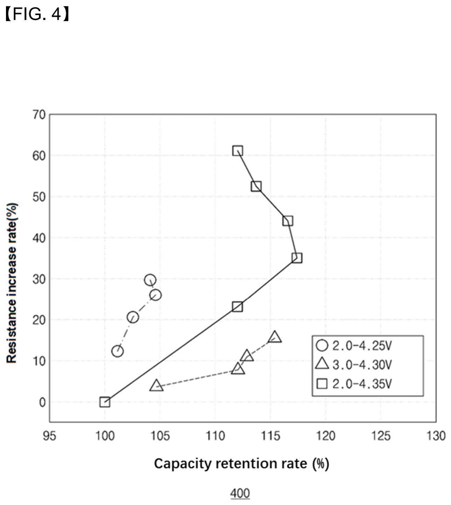

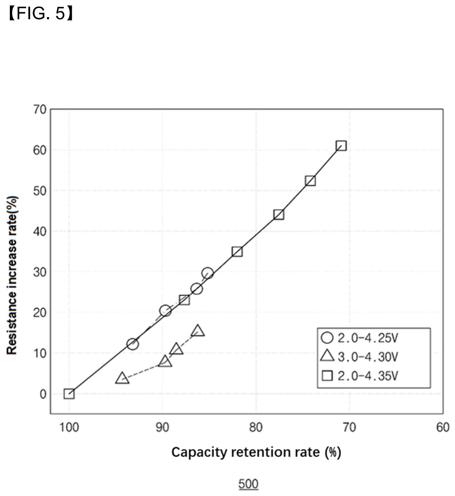

FIG. 3 is a diagram explaining an example in which a resistance increase rate diagnosis apparatus according to an embodiment determines a reference voltage range based on a discharge profile of a unit cell. FIG. 4 is a diagram showing the results of measuring a capacity change amount in a voltage range outside the reference voltage range while performing charge-discharge cycles of mutually different voltage ranges for the unit cell to be measured. FIG. 5 is a diagram showing the results of measuring a capacity change amount in a reference voltage range while performing charge-discharge cycles of mutually different voltage ranges for the unit cell to be measured.

Referring to FIG. 3, a graph 300 showing a first discharge profile indicating a voltage relative to a discharge capacity during discharge of a first unit cell, and a second discharge profile indicating a voltage relative to a discharge capacity during discharge of a second unit cell can be confirmed. Here, the first unit cell may be a unit cell including a high-manganese positive electrode material not subjected to charge-discharge cycles, and the second unit cell may be a unit cell of the same type as the first unit cell subjected to a specified number of charge-discharge cycles (e.g., 25 times).

According to an embodiment, the acquisition unit 231 may acquire a first discharge profile.
According to an embodiment, the acquisition unit 231 may acquire the first discharge profile from an external electronic apparatus and/or an external server connected via a wired and/or wireless network using a communication circuit 210. According to another embodiment, the acquisition unit 231 may acquire the first discharge profile by measuring the discharge capacity and voltage during discharge of the first unit cell via the sensor 220.

According to an embodiment, the determination unit 233 may determine the reference voltage range based on the first discharge profile of the first unit cell.

According to an embodiment, the determination unit 233 may determine the reference voltage based on a slope of the first discharge profile. According to an embodiment, the determination unit 233 may determine the voltage (e.g., 3.5 V) at an inflection point P of the first discharge profile as the reference voltage. In a specific example, the inflection point P may be defined as a point where the crystal phase mainly activated changes due to the characteristics of the high-manganese positive electrode material, for example, the lithium- and manganese-rich oxide of Chemical Formula 1, or where the type of oxidation-reduction reaction and/or the target element that mainly express the capacity during charge-discharge change.

In the graph 300, it can be confirmed that the discharge capacity at the inflection point P of the first discharge profile is higher in the first discharge profile than in the second discharge profile. This is because, in a voltage range equal to or higher than the voltage of the inflection point P (e.g., 3.5 V), the oxidation-reduction reaction of nickel (Ni) and oxygen (O) in the positive electrode active material of the high-manganese positive electrode material, for example, the lithium- and manganese-rich oxide of Chemical Formula 1, contained in the unit cell during charge-discharge proceeds predominantly, thereby decreasing the capacity of the unit cell.

On the other hand, in the graph 300, it can be confirmed that the discharge capacity at the point where the discharge is ended (e.g., the point where the discharge capacity is about 105 mAh) is higher in the second discharge profile than in the first discharge profile. This is because, in the range equal to or lower than the voltage of the inflection point P, the oxidation-reduction reaction of manganese (Mn) and oxygen (O) in the positive electrode active material of the high-manganese positive electrode material contained in the unit cell during charge and discharge, for example, the lithium- and manganese-rich oxide of Chemical Formula 1, proceeds predominantly, thereby increasing the capacity of the unit cell.

In the case of a unit cell including a high-manganese positive electrode material in this manner, there is a characteristic that the predominant reaction changes based on the inflection point of the discharge profile. That is, the predominant reaction may be equal in a voltage range equal to or higher than the inflection point or a voltage range equal to or lower than the inflection point.

According to an embodiment, the determination unit 233 may determine the reference voltage range based on the reference voltage. For example, the determination unit 233 may determine a voltage range of a reference voltage or more and an upper limit voltage or less as the reference voltage range. Here, the upper limit voltage may mean the upper limit voltage of the charge-discharge cycles to be performed on the first unit cell.

Next, the reason why the determination unit 233 determines a voltage range of a reference voltage or more and an upper limit voltage or less as the reference voltage range will be explained with reference to FIGS. 4 and 5.

Referring to FIG. 4, a graph 400 showing the resistance increase rate relative to the capacity retention rate in the voltage range of a reference voltage or less and a lower limit voltage or more of the same unit cell subjected to a specified number of different charge-discharge cycles can be confirmed. Here, the lower limit voltage may mean the lower limit voltage of the charge-discharge cycles to be performed on the first unit cell.

Referring to the graph 400, in the case of the unit cell subjected to the second charge-discharge cycle, it can be confirmed that the capacity retention rate behavior and the resistance increase rate behavior have a linear relationship. Specifically, in the case of the unit cell subjected to the second charge-discharge cycle, it can be confirmed that the resistance increase rate increases when the capacity retention rate decreases.

On the other hand, in the case of the unit cell subjected to the first charge-discharge cycle or the third charge-discharge cycle, it can be confirmed that the capacity retention rate behavior and the resistance increase rate behavior have a nonlinear relationship. Specifically, in the case of a unit cell subjected to the first charge-discharge cycle or the third charge-discharge cycle, it can be confirmed that the decrease or increase in the capacity retention rate and the decrease or increase in the resistance increase rate do not match one-to-one each other.

That is, the capacity retention rate behavior and the resistance increase rate behavior do not have a nearly linear relationship in all charge-discharge cycles, and therefore, if the determination unit 233 determines the reference voltage range as a voltage range of a reference voltage or less and a lower limit voltage or more, it may be difficult for the diagnosis unit 237 to diagnose the resistance increase rate based on the capacity retention rate.

Referring to FIG. 5, a graph 500 showing the resistance increase rate relative to the capacity retention rate in the voltage range of a reference voltage or more and an upper limit voltage or less of the same unit cell subjected to a specified number of different charge-discharge cycles can be confirmed.

Referring to the graph 500, in the case of a unit cell subjected to the first charge-discharge cycle, the second charge-discharge cycle, or the third charge-discharge cycle, it can be confirmed that the capacity retention rate behavior and the resistance increase rate behavior have a linear relationship.

That is, the capacity retention rate behavior and the resistance increase rate behavior have a nearly linear relationship in all charge-discharge cycles, and therefore, when the determination unit 233 determines the reference voltage range as a voltage range of a reference voltage or more and an upper limit voltage or less, the determination unit 237 can diagnose the resistance increase rate based on the capacity retention rate.

Thereby, the determination unit 233 can determine only the voltage range of a reference voltage or more and an upper limit voltage or less, rather than the voltage range of a reference voltage or less and a lower limit voltage or more, as the reference voltage range.

According to an embodiment, the identification unit 235 can identify the capacity retention rate in a reference voltage range of a unit cell subjected to a specified number of charge-discharge cycles. According to an embodiment, the identification unit 235 can identify the capacity change amount in the reference voltage range of the unit cell subjected to a specified number of charge-discharge cycles. The identification unit 235 can identify the capacity retention rate based on the capacity change amount.

According to an embodiment, the acquisition unit 231 can acquire the capacity change amount in the reference voltage range of the unit cell subjected to a specified number of charge-discharge cycles. According to an embodiment, the acquisition unit 231 can acquire the capacity change amount from an external electronic apparatus and/or an external server connected via a wired and/or wireless network using a communication circuit 210. According to another embodiment, the acquisition unit 231 can also measure the capacity change amount in the reference voltage range of the unit cell subjected to a specified number of charge-discharge cyclesvia a sensor 220.

According to an embodiment, the identification unit 235 can identify the capacity retention rate in the reference voltage range of the unit cell subjected to a specified number of charge-discharge cycles based on the capacity change amount.

According to an embodiment, the diagnosis unit 237 can diagnose the resistance increase rate of the unit cell based on the capacity retention rate identified by the identification unit 235. According to an embodiment, the diagnosis unit 237 can diagnose the resistance increase rate of the unit cell based on the degree of decrease in the capacity retention rate.

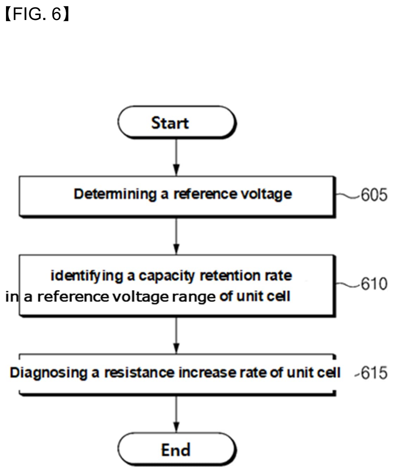

FIG. 6 is an operation flowchart of a resistance increase rate diagnosis apparatus according to an embodiment. FIG. 6 can be explained using the configuration of FIG. 2 (e.g., resistance increase rate diagnosis apparatus 200).

The embodiment shown in FIG. 6 is merely one embodiment, and the order of steps according to various embodiments of the present disclosure may differ from that shown in FIG. 6, and some steps shown in FIG. 6 may be omitted, the order between steps may be changed, or steps may be merged.

In operation 605, the resistance increase rate diagnosis apparatus 200 may determine a reference voltage range based on the discharge profile of the unit cell.

According to an embodiment, the resistance increase rate diagnosis apparatus 200 may determine the reference voltage based on a slope of the discharge profile of the unit cell. The resistance increase rate diagnosis apparatus 200 may determine the reference voltage range based on the reference voltage. For example, the resistance increase rate diagnosis apparatus 200 may determine a voltage range of a reference voltage or more and an upper limit voltage or less as the reference voltage range. Here, the upper limit voltage may mean the upper limit voltage of the charge-discharge cycles to be performed on the unit cell.

According to an embodiment, the resistance increase rate diagnosis apparatus 200 may determine the voltage at the inflection point of the discharge profile as the reference voltage.

In operation 610, the resistance increase rate diagnosis apparatus 200 may identify the capacity retention rate in the reference voltage range of the unit cell.

According to an embodiment, the resistance increase rate diagnosis apparatus 200 may identify the capacity retention rate in the reference voltage range of the unit cell subjected to a specified number of charge-discharge cycles. According to an embodiment, the resistance increase rate diagnosis apparatus 200 may identify the capacity change amount in the reference voltage range of the unit cell subjected to a specified number of charge-discharge cycles. The resistance increase rate diagnosis apparatus 200 may identify the capacity retention rate based on the capacity change amount.

In operation 615, the resistance increase rate diagnosis apparatus 200 may diagnose the resistance increase rate of the unit cell.

According to an embodiment, the resistance increase rate diagnosis apparatus 200 can diagnose the resistance increase rate of the unit cell based on the capacity retention rate identified in operation 610. According to an embodiment, the resistance increase rate diagnosis apparatus 200 can diagnose the resistance increase rate of the unit cell based on the degree of decrease in the capacity retention rate.

In the present disclosure, the words "including", "comprising", "having" and the likeshould be interpreted as meaning that, unless otherwise stated, corresponding components can be contained therein, and as further including other components without excluding the other components. Unless differently defined, all terms used here including technical or scientific terms have the same meanings as the terms generally understood by those skilled in the art to which the present disclosurepertains. The terms identical to those defined in generally used dictionaries should be interpreted as having meanings identical to contextual meanings of the related art, and are not interpreted as being ideal or excessively formal meanings unless they are definitely defined in the present disclosure.

## Claims

1. An apparatus for diagnosing a resistance increase rate of cell, the apparatus comprising:
a determination unit that determines a reference voltage range based on a discharge profile of a unit cell;
an identification unit that identifies a capacity retention rate in a reference voltage range of a unit cell subjected to a specified number of charge-discharge cycles; and
a diagnosis unit that diagnoses a resistance increase rate of the unit cell based on the identified capacity retention rate.

2. The apparatus for diagnosing a resistance increase rate of cell according to claim 1, wherein:
the determination unit,
determines a reference voltage based on a slope of the discharge profile, and
determines a reference voltage range based on the reference voltage.

3. The apparatus for diagnosing a resistance increase rate of cell according to claim 2, wherein:
the determination unit determines the voltage at an inflection point of the discharge profile as the reference voltage.

4. The apparatus for diagnosing a resistance increase rate of cell according to claim 2, wherein:
the determination unit determines a voltage range of a reference voltage or more and an upper limit voltage or less of the charge-discharge cycles, as the reference voltage range.

5. The apparatus for diagnosing a resistance increase rate of cell according to claim 1, wherein:
the identification unit identifies the capacity retention rate based on the change amount of capacity in a reference voltage range of the unit cell subjected to the specified number of charge-discharge cycles.

6. The apparatus for diagnosing a resistance increase rate of cell according to claim 1, wherein:
the unit cell comprises a positive electrode containing a lithium metal oxide in which 50 mol% or more of all the metals excluding lithium are manganese (Mn).

7. A method for diagnosing a resistance increase rate of cell, the method comprising the steps of:
an operation that determines a reference voltage range based on a discharge profile of a unit cell;
an operation that identifies a capacity retention rate in a reference voltage range of a unit cell subjected to a specified number of charge-discharge cycles; and
an operation that diagnoses a resistance increase rate of the unit cell based on the identified capacity retention rate.

8. The method for diagnosing a resistance increase rate of cell according to claim 7, wherein:
the operation that determines a reference voltage range comprises,
an operation that determines a reference voltage based on a slope of the discharge profile, and
an operation that determines a reference voltage range based on the reference voltage.

9. The method for diagnosing a resistance increase rate of cell according to claim 8, wherein:
the operation that determines a reference voltage comprises an operation that determines the voltage at an inflection point of the discharge profile as the reference voltage.

10. The method for diagnosing a resistance increase rate of cell according to claim 8, wherein:
the operation that determines a reference voltage range comprises an operation that determines a voltage range of a reference voltage or more and an upper limit voltage or less of the charge-discharge cycles, as the reference voltage range.

11. The method for diagnosing a resistance increase rate of cell according to claim 7, wherein:
the operation that identifies a capacity retention rate comprises an operation that identifies the capacity retention rate based on the change amount of capacity in a reference voltage range of the unit cell subjected to the specified number of charge-discharge cycles.

12. The method for diagnosing a resistance increase rate of cell according to claim 7, wherein:
the unit cell comprises a positive electrode containing a lithium metal oxide in which 50 mol% or more of all the metals excluding lithium are manganese (Mn).
